(19) Europäisches Patentamt
European Patent Office
Office européen des brevets

(11) **EP 3 038 436 B1**

(12) **EUROPÄISCHE PATENTSCHRIFT**

(45) Veröffentlichungstag und Bekanntmachung des Hinweises auf die Patenterteilung:
**20.10.2021 Patentblatt 2021/42**

(21) Anmeldenummer: **15197167.8**

(22) Anmeldetag: **01.12.2015**

(51) Int Cl.:
*H05K 1/02* *(2006.01)*    *H05K 3/00* *(2006.01)*
*H05K 1/11* *(2006.01)*    *H05K 3/12* *(2006.01)*
*H05K 3/34* *(2006.01)*

(54) **HERSTELLEN EINER SCHALTUNGSANORDNUNG MIT THERMISCHEN DURCHKONTAKTIERUNGEN**

PRODUCTION OF A CIRCUIT ASSEMBLY WITH THERMAL VIAS

FABRICATION D'UN SYSTEME DE COMMUTATION COMPRENANT DES TROUS METALLISES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.12.2014 AT 509342014**

(43) Veröffentlichungstag der Anmeldung:
**29.06.2016 Patentblatt 2016/26**

(73) Patentinhaber: **ZKW Group GmbH**
**3250 Wieselburg (AT)**

(72) Erfinder:
• **Weber, Emanuel**
**2500 Baden (AT)**
• **Fritz, Gerald**
**2831 Warth (AT)**
• **Biesenberger, Martin**
**3680 Persenbeug (AT)**

(74) Vertreter: **Patentanwaltskanzlei**
**Matschnig & Forsthuber OG**
**Biberstraße 22**
**Postfach 36**
**1010 Wien (AT)**

(56) Entgegenhaltungen:
**EP-A1- 0 869 704     DE-A1- 4 107 312**
**DE-A1- 19 909 505**

**Beschreibung**

Die Erfindung betrifft ein Verfahren zum Herstellen einer Schaltungsanordnung auf einer Trägerplatte, bei welchem Bauteile auf einer Oberseite der Leiterplatte aufgebracht werden, wobei die Leiterplatte thermische Durchkontaktierungen aufweist, die durch die Leiterplatte hindurch zu einer der Oberseite gegenüber liegenden Unterseite verlaufen.

Schaltungsanordnungen der hier betrachteten Art sind typischer Weise auf einer Leiterplatte ausgeführt, die als Trägerplatte eine Anzahl von elektronischen Komponenten ("Bauteile") trägt, in der Regel auf einer der beiden Seiten der Leiterplatte. Diese die Bauteile tragende Seite wird im Rahmen dieser Offenbarung in Übereinstimmung mit der üblichen Terminologie als "Oberseite" bezeichnet; die dieser gegenüber liegende Seite wird als "Unterseite" bezeichnet. Elektrische Verbindungsleitungen für die elektronischen Komponenten können sich auf beiden Seiten der Leiterplatte befinden, typischer Weise überwiegend auf der Unterseite. Die Leiterplatte besteht herkömmlicher Weise aus einem Kunststoff- oder Verbundmaterial, wie z.B. FR4, einem Epoxidharz-Glasfaser-Material; geeignete Leiterplattenmaterialien sind an sich bekannt und nicht Gegenstand der Erfindung.

Da die Bauteile aufgrund unvermeidlicher Verlustleistungen während des Betriebs Wärme erzeugen, ist in der Regel auch für eine ausreichende Ableitung der Wärme zu sorgen, um Beeinträchtigungen der Bauteile bis hin zu deren Zerstörung zu vermeiden. Nur in sehr einfachen Fällen ist eine Kühlung durch umgebende Luft und Wärmeleitung in der Leiterplatte ohne zusätzliche Maßnahmen ausreichend; zumeist müssen zusätzliche Maßnahmen zur passiven oder aktiven Kühlung getroffen werden.

Ein bekannter Ansatz der Wärmeableitung besteht darin, dass Wärmespreizflächen vorgesehen werden, d.s. Flächen aus thermisch leitfähigem Material auf einer Oberfläche der Leiterplatte, die mit dem zu kühlenden Bauteil in thermischem Kontakt stehen. Eine solche Wärmespreizfläche führt zu einer effektiven Vergrößerung der thermischen Oberfläche des Bauteils, über die Wärme abgegeben werden kann. Der thermische Haushalt auf einer Leiterplatte wird durch die zunehmende Integration sowie die immer höher werdende Packungsdichte, die sich unter anderem aufgrund von Beschränkungen des zur Verfügung stehenden Raumes für die Leiterplatte und/oder deren Bauteile ergibt, immer kritischer. Der für thermisch gestresste Bauteile notwendige Freiraum, der für Wärmespreizflächen verwendbar ist, ist daher zunehmend nicht mehr in ausreichender Größe vorhanden. Neben dem stark erhöhten Platzbedarf auf der Leiterplattenoberseite haben Wärmespreizflächen den weiteren Nachteil, dass die Wärmeabfuhr nur an die Umgebungsluft und nicht in einen Kühlkörper erfolgt.

Ein anderer Ansatz der Wärmeableitung von thermisch beanspruchten Bauteilen sind thermische Durchkontaktierungen, oft Thermo-Vias oder (englisch) "thermal vias" genannt. Ein Thermo-Via stellt eine thermisch (sowie in der Regel auch elektrisch) leitfähige Verbindung von der Leiterplattenoberseite auf die -unterseite dar, um einen Wärmetransport quer durch die Leiterplatte zu erleichtern und den thermischen Widerstand des Leiterplattenmaterials zu überbrücken. Bei der Verwendung von Thermo-Vias müssen jedoch drei kritische Punkte berücksichtigt werden:

1. Übliche Thermo-Vias sind mit metallischem Material ausgeführt und stellen daher eine elektrisch leitfähige Verbindung zu der Leiterplattenunterseite dar. Falls eine elektrische Isolation zum darunter liegenden Kühlkörper benötigt wird, muss diese daher zusätzlich implementiert werden.

2. Um thermisch am effizientesten zu sein, müsste ein Thermo-Via direkt unter einem Pad-Anschluss des thermisch gestressten Bauteils angeordnet sein. Herkömmliche Thermo-Vias sind jedoch nicht geschlossen, weshalb sich ein Loch von der Leiterplattenoberseite auf die Unterseite ergibt. Bei der Verlötung wird daher Lot durch Vias, die unter den Bauteil-Pads angeordnet sind, durch Kapillar- sowie Gravitationskräfte nach unten weggezogen; dadurch vermindert sich die Lötqualität drastisch. Im Extremfall steht an der Leiterplattenoberfläche nicht mehr ausreichend Lot zur Verfügung, um das Bauteil elektrisch zu kontaktieren.

3. Obwohl Thermo-Vias eine thermisch hoch leitfähige Verbindung darstellen, ist die zur Wärmeabfuhr verfügbare Oberfläche in ungefüllten Vias sehr gering. Das Wärmeleitvermögen wird lediglich durch die Dicke der Kupferschicht in den Vias bestimmt.

Daher liegen die Thermo-Vias in bekannten Anordnungen zumeist außerhalb der zu verlötenden Flächen, somit nicht direkt in den Bauteil-Pads, was die Ableitung der Wärme erschwert; zudem werden erweiterte Pad-Flächen notwendig, sodass Thermo-Vias, die außerhalb der Bauteil-Pads liegen, wiederum zu erhöhtem Platzbedarf führen.

Ein bekannter Lösungsansatz sieht vor, dass Thermo-Vias in den Bauteil-Pads platziert und bereits vor der Bestückung mit Bauteilen, beispielsweise durch den Hersteller der Leiterplatte, verfüllt ("plugged") ausgeführt werden. Derartige verfüllte Vias erfüllen zwar die technischen Vorgaben, sind jedoch teuer.

Erschwerend kommt hinzu, dass Thermo-Vias häufig nicht an der effektivsten Stelle angeordnet werden können und somit nicht einen optimalen Wärmeabtransport leisten. Außerdem weisen unbefüllte Vias nur eine geringe Oberfläche für die Wärmeabfuhr auf und ergeben somit ein beschränktes Leitvermögen des Wärmepfades vom Bauteil zum Kühlkörper.

EP 0 869 704 A1 beschreibt ein Verfahren gemäß dem Oberbegriff des Anspruchs 1, wobei nach dem Verfüllen der thermischen Durchkontaktierungen eine thermische Klebschicht auf der Unterseite gebildet wird. In DE 199 09 505 A1 ist ein Aufbringen eines Siebdruckmaterials auf der Unterseite des Trägerkörpers beschrieben, das in die Durchkontaktierungen eindringt.

Es ist daher eine Aufgabe der Erfindung, die oben genannten Nachteile zu überwinden und einen einfachen und kosteneffizienten Weg zum Herstellen effizienter Thermo-Vias zu schaffen.

Diese Aufgabe wird ausgehend von einem Verfahren der eingangs genannten Art dadurch gelöst, dass erfindungsgemäß

a) die thermischen Durchkontaktierungen an der Unterseite durch Aufbringen einer Schicht thermisch leitfähigen, elektrisch isolierenden Materials, das nicht in die thermischen Durchkontaktierungen eindringt, verschlossen werden, und sodann

b) die thermischen Durchkontaktierungen von der Oberseite her mit Lötmaterial verfüllt werden.

Diese erfindungsgemäße Lösung beinhaltet als einen Grundgedanken, dass eine Schicht thermisch leitfähigen, elektrisch isolierenden Materials in einem ersten Prozessschritt auf die noch unbestückte Leiterplattenrückseite aufgebracht wird, beispielsweise durch ein Druckverfahren an sich bekannter Art. Als solches Material kommt insbesondere sogenanntes Thermal-Interface-Material (TIM), wie z.B. Wärmeleitpaste, in Betracht. Durch die

Verwendung dieser Schicht sind die Vias nach unten hin geschlossen und verhindern ein unkontrolliertes Wegfließen des Lotes während eines nachfolgenden Lötvorgangs. Im Allgemeinen ist unter "thermisch leitfähigem Material" oder "gut wärmeleitfähigem Material" ein Material zu verstehen, welches eine vergleichsweise hohe thermische Leitfähigkeit hat, durch die es zur Verwendung in einer thermischen Durchkontaktierung geeignet ist. Insbesondere ist es günstig, wenn die thermische Leitfähigkeit über jener der Trägerplatte liegt, vorzugsweise um mindestens eine Größenordnung oder um mehrere Größenordnungen.

Aufgrund der Erfindung kann der thermische Pfad vom Bauteil auf der Leiterplatte zum Kühlkörper durchgängig mit gut wärmeleitfähigen Materialien realisiert werden (Abfolge Lot - Kupfer - mit Lot gefülltes Via - TIM). Die erfindungsgemäße Schicht thermisch leitfähigen, elektrisch isolierenden Materials ermöglicht insbesondere

1. bessere Wärmeanbindung von der Leiterplattenrückseite zum Kühlkörper,
2. elektrische Isolierung von Leiterplattenrückseite zum Kühlkörper,
3. eine mechanische Barriere für das Lot, die ein Durchlaufen des Lots durch Thermo-Vias an die Leiterplattenunterseite verhindert.

Diese Schicht führt zu keinen oder nur geringfügigen zusätzlichen Kosten, und dennoch kann eine optimale thermische Ableitung der Wärme von Bauteilen auf der Leiterplattenoberseite zum Kühlkörper hin sichergestellt werden.

Das erfindungsgemäße Verfahren eignet sich insbesondere zur Verwendung bei der Herstellung einer Leiterplatte eines Fahrzeugscheinwerfers, wobei die Leiterplatte eine Trägerplatte mit zumindest einer thermischen Durchkontaktierung umfasst, die im Bereich eines Anschlusspads eines lichterzeugenden Bauteils liegt. Diese Durchkontaktierung wird somit nach dem erfindungsgemäßen Verfahren verfüllt.

In einer besonders günstigen Weiterbildung der Erfindung kann einerseits das Kühlvermögen zusätzlich gesteigert und andererseits eine einfache Gestaltung der TIM-Schicht ausgenutzt werden, wenn die in Schritt a) aufgebrachte Schicht die Öffnung mehrerer Durchkontaktierungen an der Unterseite gemeinsam überdeckt.

In einer besonders vorteilhaften Variante können die thermischen Durchkontaktierungen in Schritt a) in ihren Bereichen zwischen der Unter- und der Oberseite zumindest überwiegend frei bleiben und erst in Schritt b) verfüllt werden.

Außerdem kann Schritt b) durch ein Verlötungsverfahren unter erhöhter Temperatur, vorzugsweise einen Reflow-Prozess, erfolgen.

Die Bestückung der Bauteile kann vorteilhafter Weise zwischen den Schritten a) und b) erfolgen, beispielsweise dadurch, dass nach Schritt a) erst Lötpaste auf die thermischen Durchkontaktierungen auf der Oberseite aufgebracht wird und sodann die Bauteile bestückt werden.

Die Erfindung samt weiterer Vorzüge und Ausgestaltungen wird im Folgenden anhand eines nicht einschränkenden Ausführungsbeispiels näher erläutert, das in den beigefügten Zeichnungen dargestellt ist. Die Zeichnungen zeigen:

Fig. 1       eine Leiterplatte mit Thermo-Vias, die nach herkömmlicher Art erzeugt worden sind;

Fig. 2a—c    die Herstellung einer Leiterplatte mit einer Lötung unter Verwendung des erfindungsgemäßen Verfahrens; und

Fig. 3       die fertig gestellte Schaltungsanordnung.

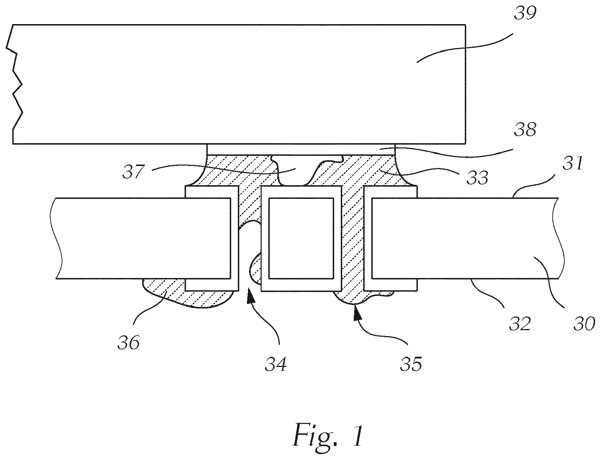

In Fig. 1 ist eine Leiterplatte 30 gezeigt, in der zwei mit Lot gefüllte Thermo-Vias 34, 35 im Bereich eines Pads 38 eines Bauteils 39 vorgesehen sind, das auf der Oberseite 31 der Leiterplatte 30 angeordnet ist und das über die mit Lot 33 gefüllten Thermo-Vias 34, 35 über die Unterseite 32 gekühlt werden soll. Anhand des Beispiels dieser Leiterplatte 30 sind in Fig. 1 die Probleme illustriert, die mit Thermo-Vias dieser Art auftreten können. Beide Vias sind zur Unterseite 32 hin offen. Dies führt beispielsweise bei dem Via 34 dazu, dass es unvollständig mit Lot 33 verfüllt wurde und/oder Lot an die Unterseite 32 abgeflossen ist; abgeflossenes Lot kann z.B. abgetropft sein oder zur Seite abgelaufen sein, wo es gegebenenfalls störende Tropfen 36 bilden kann. Auch wenn ein Via 35 vollständig mit Lot 33 gefüllt bleibt, muss damit gerechnet werden, dass während des Lötvorgangs ein mehr oder weniger großer Teil des Lots durch das Via abrinnt, was dazu führen kann, dass im Bereich des Pads 38 auf der Oberseite 31 Lot fehlt, sodass sich Lunker 37 im Lot bilden, die die thermische Leitfähigkeit verringern und somit die Wärmeableitung vom Bauteil 39 zur Unterseite 32 hin behindern.

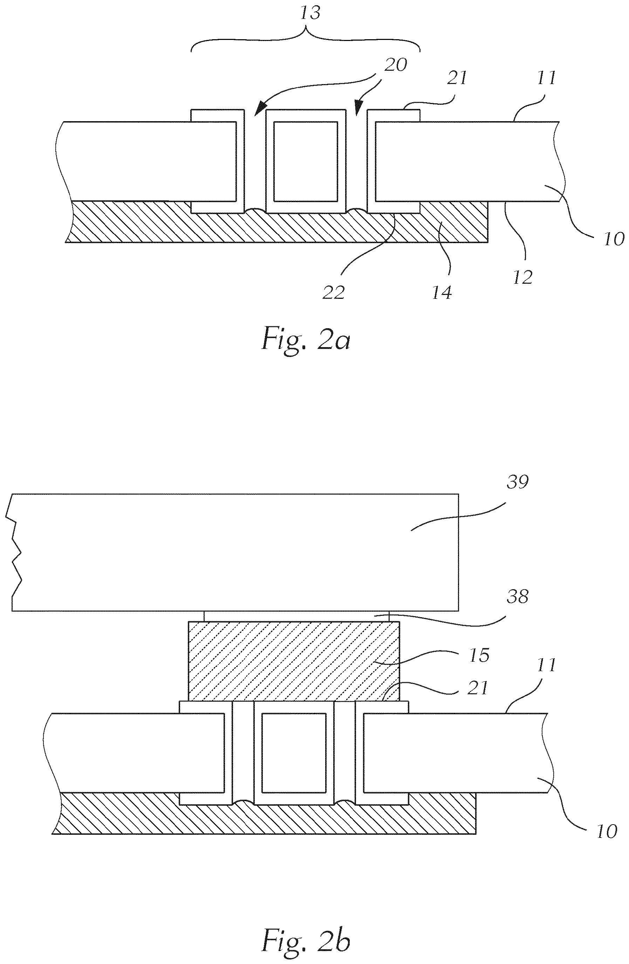

Gemäß der Erfindung wird, bevor die Leiterplatte mit einer Lötung ausgestattet wird, an der Unterseite der Leiterplatte eine Schicht eines TIM aufgedruckt. Das TIM weist eine hohe thermische Leitfähigkeit sowie eine ausreichende elektrische Isolationsfestigkeit auf. Dies gestattet es, Thermo-Vias direkt in die Pads thermisch gestresster Bauteile - wie z.B. LEDs von Scheinwerfern - zu platzieren, ohne dass dies zu den oben beschriebenen Nachteilen führt. Dies wird nachstehend mit dem Ausführungsbeispiel der Fig. 2a bis 2c erläutert.

Fig. 2a zeigt eine Leiterplatte 10, die vom Aufbau her der Leiterplatte 30 der Fig. 1 entspricht. Die Leiterplatte besteht beispielsweise aus FR-4-Material; im Bereich 13 eines Pads, das für ein in einem späteren Schritt auf die Oberseite 11 der Leiterplatte aufzubringendes Bauteil vorgesehen ist, befinden sich zwei Thermo-Vias 20 mit einem Durchmesser von typischer Weise 350 $\mu$m; aber auch größere Durchmesser sind dank der Erfindung möglich, wobei größere Vias zudem leichter befüllbar sind und eine höhere thermische Gesamtleitfähigkeit bieten. Die zwei Vias 20 sind in dem gezeigten Ausführungsbeispiel repräsentativ für eine beliebige Anzahl von ein, zwei, drei oder mehr Thermo-Vias, wobei die Anzahl je nach Anwendung und gewünschtem Wärmedurchsatz (Kühlleistung) zur Unterseite 12 gewählt werden kann. Insbesondere kann je Bauteil ein Thermo-Via oder zwei oder mehr vorgesehen sein; beispielsweise werden in einer LED-Leiterplatte eines Scheinwerfers je einer LED des Typs OSLON Compact typischer Weise sechs Thermo-Vias zugeordnet. Die Thermo-Vias 20 bestehen nach bekannter Art aus je einer - in der Regel zylindrischen - Bohrung, deren Innenfläche mit einem elektrisch leitfähigen Material - z.B. Kupfer - ausgekleidet ist und an den beiden Öffnungen auf der Ober- und Unterseite in je einen flächigen Bereich 21, 22 übergeht. Der Bereich 21 auf der Oberseite 11 und jener 22 auf der Unterseite 12 können hinsichtlich der Flächenform übereinstimmen oder (nicht gezeigt) verschieden groß sein.

Gemäß der Erfindung wird wie in Fig. 2a gezeigt in einem ersten Schritt eine Schicht 14 aus einem TIM, beispielsweise einer gegenüber den Temperaturen des späteren Lötvorgangs wärmefesten Wärmeleitpaste, auf die Unterseite 12 gedruckt, sodass die Vias 20 an ihren unteren Öffnungen verschlossen werden. Bevorzugt deckt die Schicht 14 den gesamten Bereich 22 der Vias 20 ab und kann zudem noch um den Rand des Bereichs 22 überstehen, wodurch eine elektrische Isolierung der Vias an der Unterseite erzielt wird. Das TIM der Schicht 14 wird gemäß der Erfindung über die Vias gedruckt, wobei es (beispielsweise aufgrund seiner Viskosität) nicht in die Vias eindringt; die Grenzfläche der TIM-Schicht zur Unterseite eines Vias wird nur geringfügig sichelförmig (im Längsschnitt betrachtet). Die Größe eines einzelnen Bereichs der aufgedruckten Schicht 14 liegt typischer Weise im Bereich um einen Quadratzentimeter, wobei diese Bereiche in der Regel nicht ganzflächig, sondern strukturiert sind.

Sodann wird - Fig. 2b - nach an sich bekannter Art Lotpaste 15 auf der Leiterplattenoberseite aufgedruckt und das Bauteil 39 einschließlich seines der Leiterplatte 10 zugewandten Bauteil-Pads 38 wird bestückt. Das Pad 38 dient hier sowohl der elektrischen als auch der thermischen Kontaktierung des Bauteils 39; in anderen Anwendungsfällen kann ein Pad auch lediglich für eine thermische Anbindung verwendet werden. Die Lotpaste ist ein SnAgCu-Lot an sich bekannter Art mit einem Silberanteil von z.B. 3%; ein höherer Silberanteil kann die thermische Leitfähigkeit verbessern, führt jedoch zu dem Risiko der Ausbildung einer unerwünschten, spröden $Ag_3Sn$-Phase.

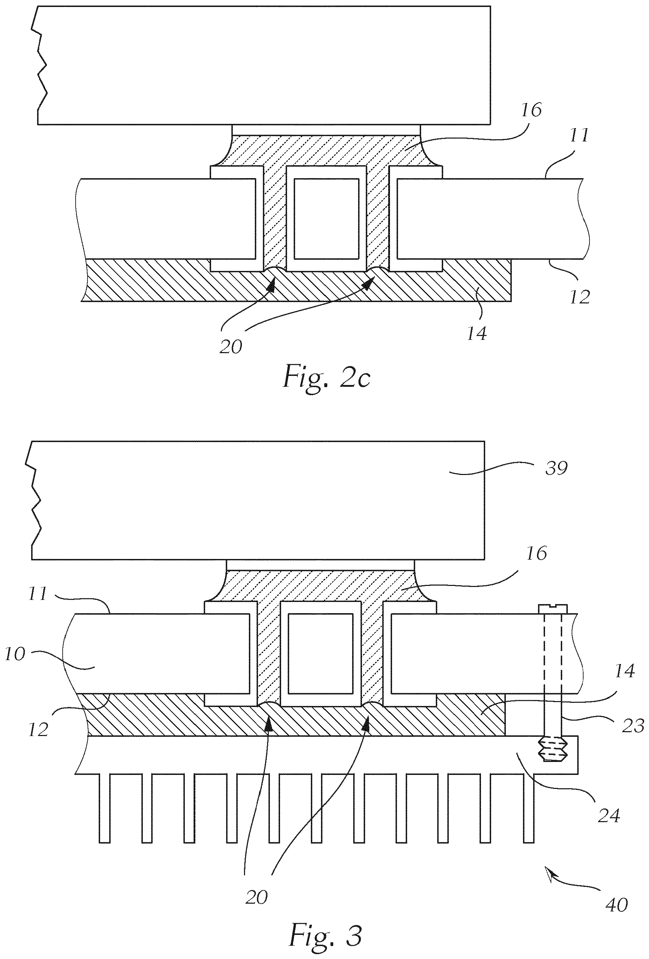

Daraufhin wird die Anordnung in einen Reflow-Ofen gebracht, wo der eigentliche Lötvorgang durch Reflow-Lötung erfolgt: Das Lot über den Pads mit den Thermo-Vias 20 verflüssigt sich und fließt in die Hohlräume derselben. Fig. 2c zeigt das Ergebnis dieses Vorgangs. Das Lot 16 füllt die Vias 20 vollständig. Die Menge an Lot 16, die zur Via-Befüllung benötigt wird, kann durch Lotpasten-Erweiterungen an der Leiterplattenoberseite 11 bereitgestellt werden (nicht gezeigt). Durch die erfindungsgemäß auf der Unterseite aufgebrachte TIM-Schicht 14 wird jedoch ein Wegfließen des Lots 16 auf die Leiterplattenunterseite 12 verhindert, ebenso wie die Ausbildung unerwünschter Lücken oder Blasen im Lot 16, die sonst (vgl. Fig. 1) infolge Verlusts von Lotmaterial auftreten könnten.

Nach dem Lötvorgang kann, sofern gewünscht, über der Unterseite 12 der Leiterplatte 10 auf die TIM-Schicht 14 ein Kühlkörper 24 aufgebracht werden, der durch seine Formgebung den Wärmeübergang z.B. zur kühlenden Luft oder (nicht gezeigt) einem Kühlmedium zusätzlich verbessert. Der Kühlkörper 24 kann direkt auf die TIM-Schicht 14 oder vermittels einer (nicht gezeigten) Kleberschicht aufgebracht werden, wobei zur mechanischen Fixierung eine Befestigung mittels einer Schraubverbindung 23 oder dgl. vorgesehen sein kann.

Fig. 3 zeigt die erhaltene Schaltungsanordnung 40 des Ausführungsbeispiels. Selbstverständlich ist das gezeigte Ausführungsbeispiel nicht einschränkend für die Erfindung zu verstehen, sondern dient lediglich der Illustration der Erfindung, die sich auf eine Vielzahl möglicher Ausführungsformen erstreckt.

Als Ergebnis des erfindungsgemäßen Verfahrens besteht eine thermisch hoch leitfähige Verbindung vom Bauteil-Pad BP über die Thermo-Vias 20 bis direkt zum Kühlkörper 24. Über die mit Lot befüllten Vias wird auch, im Vergleich zu einer Ausführung mit ungefüllten Vias, die zur Wärmeabfuhr zur Verfügung stehende effektive Querschnittsfläche in der Leiterplatte 10 stark vergrößert. Die befüllten Vias weisen einen thermischen Widerstand $R_{th}$ auf, welcher typischer Weise etwa 2/3 des thermischen Widerstands $R_{th}^0$ des entsprechenden ungefüllten Vias ist und durch eine Vergrößerung der Querschnittsfläche der Vias noch weiter verringert werden kann. Das im Ausführungsbeispiel verwendete TIM hat vorzugsweise eine Spannungsfestigkeit von 20 bis 30 kV/mm. Ein solcher Wert der Spannungsfestigkeit ist günstig, um ohne weitere Isolierung zum Kühlkörper 24 eine ausreichende gegenseitige elektrische Isolierung von Bauteilen auf der Leiterplatte zu erreichen, beispielsweise von in Serie geschalteten LEDs in einer LED-Leiterplatte eines Scheinwerfers.

Die hohe Wärmeleitfähigkeit des TIM gestattet es, dass es ganzflächig in Form der Schicht 14 aufgetragen werden kann. Es ist deshalb nur ein Printing-Schritt erforderlich. Dadurch, dass das Lot 16 in den Thermo-Vias 20 die TIM-Schicht 14 thermisch kontaktiert, vergrößert sich der wirksame Querschnitt des wärmeleitenden Pfads.

**Patentansprüche**

1. Verfahren zum Herstellen einer Schaltungsanordnung (40) auf einer Trägerplatte (10), bei welchem Bauteile (39) auf einer Oberseite (11) der Trägerplatte (10) aufgebracht werden, wobei die Trägerplatte (10) thermische Durchkontaktierungen (20) aufweist, die durch die Trägerplatte (10) hindurch zu einer der Oberseite (11) gegenüber liegenden Unterseite (12) verlaufen, **dadurch gekennzeichnet, dass**

   a) die thermischen Durchkontaktierungen (20) an der Unterseite (12) durch Aufbringen einer Schicht (14) thermisch leitfähigen, elektrisch isolierenden Materials, das nicht in die thermischen Durchkontaktierungen (20) eindringt, verschlossen werden, und sodann
   b) die thermischen Durchkontaktierungen (20) von der Oberseite (11) her mit Lötmaterial (15, 16) verfüllt werden.

2. Verfahren nach Anspruch 1, **dadurch gekennzeichnet, dass** die in Schritt a) aufgebrachte Schicht (14) an der Unterseite (12) die Öffnung mehrerer Durchkontaktierungen (20) gemeinsam überdeckt.

3. Verfahren nach Anspruch 1 oder 2, **dadurch ge-**

**kennzeichnet, dass** die thermischen Durchkontaktierungen (20) in Schritt a) in ihren Bereichen zwischen der Unter- und der Oberseite zumindest überwiegend frei bleiben und erst in Schritt b) verfüllt werden.

4. Verfahren nach einem der vorhergehenden Ansprüche, **dadurch gekennzeichnet, dass** Schritt b) durch ein Verlötungsverfahren unter erhöhter Temperatur, vorzugsweise einem Reflow-Prozess, erfolgt.

5. Verfahren nach einem der vorhergehenden Ansprüche, **dadurch gekennzeichnet, dass** nach Schritt a) und noch vor Schritt b) Lötpaste (15) auf die thermischen Durchkontaktierungen (20) auf der Oberseite (11) aufgebracht wird und sodann die Bauteile (39) bestückt werden.

6. Verwendung des Verfahrens nach einem der vorhergehenden Ansprüche bei der Herstellung einer Leiterplatte eines Fahrzeugscheinwerfers, wobei die Leiterplatte eine Trägerplatte (10) mit zumindest einer thermischen Durchkontaktierung (20) umfasst, die im Bereich eines Anschlusspads eines lichterzeugenden Bauteils (39) liegt.

**Claims**

1. Method of producing a circuit arrangement (40) on a support plate (10), wherein components (39) are attached onto an top surface (11) of the support plate (10), the support plate (10) having thermal vias (20) which extend through the support plate (10) to a bottom surface (12) located opposite the top surface (11), **characterised in that**

   a) the thermal vias (20) are closed on the bottom surface (12) by applying a layer (14) of thermally conductive, electrically insulating material which does not penetrate into the thermal vias (20), and subsequently
   b) the thermal vias (20) are filled with solder material (15, 16) from the top surface (11).

2. The method of claim 1, **characterised in that** the layer (14) applied on the bottom surface (12) in step a) jointly covers the openings of several vias (20).

3. The method of claim 1 or 2, **characterised in that** in step a) the thermal vias (20) remain at least predominantly free in their regions between the lower and top surface and are only filled in step b).

4. The method of any one of the preceding claims, **characterised in that** step b) is carried out by a soldering process at elevated temperature, preferably a reflow process.

**5.** The method of any one of the preceding claims, **characterised in that** after step a) and before step b), soldering paste (15) is applied to the thermal vias (20) on the top surface (11) and subsequently the components (39) are fitted.

**6.** Use of the method of any one of the preceding claims in producing a printed circuit board of a vehicle headlamp, the printed circuit board comprising a support plate (10) having at least one thermal via (20) located in the region of a connection pad of a light-generating component (39).

**Revendications**

**1.** Procédé de fabrication d'un circuit (40) sur une plaque de support (10), dans lequel des composants (39) sont appliqués sur une face supérieure (11) de la plaque de support (10), la plaque de support (10) présentant des vias thermiques (20) qui s'étendent à travers la plaque de support (10) jusqu'à une face inférieure (12) opposée à la face supérieure (11), **caractérisé en ce que**

　　a) les vias thermiques (20) sont fermés sur la face inférieure (12) par l'application d'une couche (14) de matériau thermoconducteur et électriquement isolant qui ne pénètre pas dans les vias thermiques (20), puis
　　b) les vias thermiques (20) sont remplies de matériau de soudure (15, 16) de la face supérieure (11).

**2.** Procédé selon la revendication 1, **caractérisé en ce que** la couche (14) appliquée à l'étape a) couvre l'ouverture de plusieurs vias (20) ensemble sur la face inférieure (12).

**3.** Procédé selon la revendication 1 ou 2, **caractérisé en ce que** les vias thermiques (20) dans l'étape a) restent libres au moins en grande partie dans leurs régions entre les faces inférieure et supérieure et ne sont remplies que dans l'étape b).

**4.** Procédé selon l'une quelconque des revendications précédentes, **caractérisé en ce que** l'étape b) est réalisée par un procédé de brasage à température élevée, de préférence un procédé de refusion.

**5.** Procédé selon l'une quelconque des revendications précédentes, **caractérisé en ce qu'**après l'étape a) et encore avant l'étape b), une pâte à souder (15) est appliquée sur les vias thermiques (20) sur la face supérieure (11) et ensuite les composants (39) sont montés.

**6.** Utilisation du procédé selon l'une quelconque des revendications précédentes dans la fabrication d'une carte de circuit imprimé d'un projecteur de véhicule, la carte de circuit imprimé comprenant une plaque de support (10) avec au moins un via thermique (20) situé dans la région d'une plage de connexion d'un composant générateur de lumière (39).

*Fig. 1*

Fig. 2a

Fig. 2b

*Fig. 2c*

*Fig. 3*

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0869704 A1
- DE 19909505 A1